Europäisches Patentamt

European Patent Office

Office européen des brevets

(19)

(11) Numéro de publication: **0 140 396**
**B1**

(12) **FASCICULE DE BREVET EUROPÉEN**

(45) Date de publication du fascicule du brevet: 08.03.89

(51) Int. Cl.⁴: **G 06 G 7/122**, G 01 R 13/20

(21) Numéro de dépôt: **84200941.7**

(22) Date de dépôt: **29.06.84**

(54) **Procédé et dispositif de reconstitution d'un signal analogique.**

(30) Priorité: **03.10.83 FR 8315701**

(43) Date de publication de la demande: **08.05.85 Bulletin 85/19**

(45) Mention de la délivrance du brevet: **08.03.89 Bulletin 89/10**

(84) Etats contractants désignés: **DE FR GB NL**

(56) Documents cité: **FR-A-2 337 343**

**ELECTRONIC DESIGN, vol. 30, no. 18, septembre 1982, pages 129-138, Waseca, MN, Denville, N.J., US; M.J. RIEZENMAN: "Even in a digital age, scopes remain the instrument"**

(73) Titulaire: **Laboratoires d'Electronique et de Physique Appliquée L.E.P., 3, Avenue Descartes, F-94450 Limeil- Brévannes (FR)**

(84) Etats contractants désignés: **FR**

(73) Titulaire: **N.V. Philips' Gloeilampenfabrieken, Groenewoudseweg 1, NL- 5621 BA Eindhoven (NL)**

(84) Etats contractants désignés: **DE GB NL**

(72) Inventeur: **Boutigny, Pierre- Henri, Société Civile S.P.I.D. 209, rue de l'Université, F-75007 Paris (FR)**

(74) Mandataire: **Landousy, Christian, Société Civile S.P.I.D. 209, Rue de l'Université, F-75007 Paris (FR)**

## Description

L'invention concerne un procédé de reconstitution d'un signal analogique E(t) sous la forme d'un signal numérique reconstitué utile X(t), destiné à être visualisé et/ou traité, formé par période τ d'analyse, soit des échantillons du signal reconstitué calculé S(t) restitués dans le mode de représentation signal, soit des valeurs minimale et maximale du signal analogique E(t) restituées dans le mode de représentation enveloppe. Elle concerne bien évidemment un dispositif mettant en oeuvre le procédé ainsi qu'un oscilloscope utilisant un tel dispositif.

Il est connu de l'art antérieur que dans le domaine de l'oscilloscopie numérique des difficultés apparaissent pour visualiser d'une façon correcte les signaux numériques issus des signaux analogiques usuels. En effet, selon le rapport entre la fréquence des signaux analogiques à analyser et celle du signal d'échantillonnage de fausses représentations apparaissent qui peuvent ôter toute signification à la représentation donnée sur l'écran. Aussi pour lever cette difficulté une solution a été apportée en déterminant, sur une période d'échantillonnage appelée période τ d'analyse, les valeurs maximale et minimale prises par le signal analogique, méthode appelée MIMAC. Ceci est décrit dans le document FR-A-2 337 343. Ainsi par période τ d'analyse, on visualise le minimum et le maximum du signal analogique c'est-à-dire l'enveloppe du signal analogique, ce mode étant nommmé ci-après mode enveloppe.

D'autre part les valeurs numériques acquises à chaque période τ d'analyse peuvent être également toutes visualisées successivement. Ce mode de visualisation du signal est appelé ci-après mode signal.

Dans ce second cas pour lever certaines ambiguïtés d'interprétation des représentations, liées en particulier au fait que l'oeil est plus enclin à associer deux points lumineux rapprochés dans l'espace plutôt que dans le temps, des méthodes et des dispositifs ont été proposés dans l'article intitulé: "De l'oscilloscope conventionnel à l'oscilloscope à mémoire numérique" de R. BRUN publié dans la revue "Acta electronica" vol. 24, n° 4 1981/1982, pages 301 à 308, où il est décrit des méthodes d'interpolation linéaire et des méthodes de filtrage pour disposer d'une représentation améliorée. Ainsi est-il proposé un dispositif qui permet d'effectuer une interpolation linéaire entre deux points consécutifs, c'est-à-dire de relier deux points consécutifs par un segment de droite. On dispose ainsi d'une aide de l'interprétation qui permet de mieux estimer l'allure du signal reconstruit.

Il ne reste pas moins vrai que dans le cas de signaux rapides, pour lesquels les fréquences maximales de leur spectre de fréquences se rapprochent de la fréquence appelée fréquence de Shannon, moitié de la fréquence d'échantillonnage Fe, il devient impossible d'interpréter les représentations visualisées.

De même des méthodes de filtrage numérique sont utilisés pour assurer une représentation plus exacte des signaux reconstruits, telles que décrites dans la même publication que précédemment.

Mais dans tous les cas cités la fréquence de Shannon est une limite qu'il n'est pas possible de dépasser et même d'approcher, dans les situations réelles, pour atteindre des résultats corrects.

De même les dispositifs connus offrent à l'utilisateur la possibilité d'effectuer un choix manuel, mais global, entre le mode signal et le mode enveloppe, l'utilisateur devant périodiquement s'assurer quelle est la meilleure représentation offerte, sans pouvoir sélectionner son choix par période unitaire d'analyse. Il n'est également pas possible dans ces dispositifs de connaître l'erreur commise dans la représentation proposée.

Un premier avantage de l'invention est que le choix de la représentation du signal reconstitué utile X(t) en mode signal ou en mode enveloppe, se fait automatiquement par le dispositif lui-même sans intervention de l'utilisateur, avec simultanément la visualisation de l'erreur commise ayant présidé au choix effectué.

Un second avantage de l'invention est de pouvoir intervenir sur la bande passante du signal reconstitué utile en adaptant le choix des fonctions de reconstitution aux signaux à traiter.

Un troisième avantage de l'invention est que les circuits d'entrée très rapides sont peu nombreux, et le traitement numérique subséquent permet d'éliminer bon nombre de circuits de commande classiques d'un oscilloscope, qui peuvent devenir beaucoup plus lents, diminuant aussi le coût de ces matériels.

Dans ce qui va suivre l'écriture $<A>$ signifie qu'il s'agit de la valeur moyenne de A déterminée sur une période précisée ci-dessous. De même l'écriture $S_k$ ou $f_k(t)$ signifie qu'il s'agit de vecteurs à k dimensions ($S_n$ ou $f_n$ étant la $n^{ième}$ composante).

Dans ce but l'invention concerne un procédé et un dispositif de reconstitution d'un signal analogique E(t) tels qu'indiqués dans les préambules, des revendications 1, 11, 12 et 13, dans laquelle le procédé de reconstitution d'un signal analogique E(t), sous la forme d'un signal numérique reconstitué utile X(t), destiné à être séquentiellement visualisé et/ou traité, formé par période τ d'analyse, soit des échantillons d'un signal reconstitué calculé S(t), restitués dans le mode de représentation signal, soit des valeurs minimale et maximale du signal analogique E(t) restituées dans le mode de représentation enveloppe, est caractérisé en ce qu'il comprend les étapes suivantes:

- multiplication du signal analogique E(t) séparément par k fonctions du temps $f_k(t)$ pour obtenir k produits E(t) $\cdot f_k(t)$, et calcul de leurs moyennes respectives pour obtenir k moyennes $<E(t) \cdot f_k(t)>$ à l'issue de chaque période τ d'analyse, les fonctions $f_k(t)$ étant choisies de sorte que la bande passante qu'elles couvrent soit adaptée à la bande passante du signal analogique E(t);
- détermination des k coefficients $S_k$ par $S_k = M^{-1} \cdot <E(t) \cdot f_k(t)>$ où $M^{-1}$ est l'inverse de la matrice M telle que

2

$$M = \begin{vmatrix} \langle f_1.f_1 \rangle & \ldots\ldots\ldots\ldots\ldots & \langle f_n.f_1 \rangle \\ & \cdot & \cdot \\ & \cdot & \cdot \\ \langle f_1.f_n \rangle & \ldots\ldots\ldots\ldots\ldots & \langle f_n.f_n \rangle \end{vmatrix}$$

où $f_1$ et $f_n$ représentent respectivement la première fonction $f_1(t)$ et la dernière fonction $f_n(t)$ des k fonctions $f_k(t)$,
- détermination du signal reconstitué calculé S(t) par: $S(t) = S_k \cdot f_k(t)$;
- sélection du mode de représentation enveloppe ou signal, selon un critère de choix de représentation, basé sur au moins une fonction d'erreur déterminée entre le signal reconstitué calculé S(t) et le signal analogique E(t);
- visualisation et/ou traitement du signal reconstitué utile X(t).

L'invention concerne également un dispositif d'obtention d'un signal reconstitué utile X(t) à partir d'un signal analogique E(t) pour la mise en oeuvre du procédé, signal X(t) destiné à être séquentiellement visualisé et/ou traité, formé par période τ d'analyse, soit des échantillons d'un signal reconstitué calculé S(t) restitués dans le mode de représentation signal, soit des valeurs minimale et maximale du signal analogique E(t) restituées dans le mode de représentation enveloppe, caractérisé en ce que le signal analogique E(t) entre dans un processeur analogique qui comprend:
- un circuit de traitement opérant le traitement du signal analogique E(t) par des fonctions $f_k(t)$ adaptées à la bande passante du signal E(t), le circuit de traitement étant constitué de k circuits de multiplication du signal E(t) par les k fonctions $f_k(t)$, respectivement suivis de k dispositifs d'intégration, respectivement suivis de k échantillonneurs dont les k sorties sont réunies aux entrées de l'organe de mémorisation et de numérisation,
- et des moyens de choix du mode de représentation basés sur au moins une fonction d'erreur caractérisant l'écart entre le signal reconstitué calculé S(t) et le signal analogique E(t), les sorties de l'organe de mémorisation et de numérisation entrant dans un dispositif de calcul et de test qui fournit:
  a) à un organe de visualisation et/ou de traitement des signaux de synchronisation et des signaux de cadence, ainsi que le signal reconstitué utile X(t) et éventuellement les signaux de la ou des fonctions d'erreur afin de permettre le choix du mode de représentation, pour chaque période τ d'analyse,
  b) des signaux de remise à zéro au processeur analogique et des signaux de synchronisation à un cadenceur; celui-ci imposant les cadences de fonctionnement au processeur analogique, à l'organe de mémorisation et de numérisation et au dispositif de calcul et de test.
D'autres dispositifs sont caractérisés dans les revendications 12 et 13.
L'invention sera mieux comprise à l'aide de la description suivante de quelques modes de réalisation de l'invention, ladite description étant accompagnée de dessins dans lesquels:
la figure 1 représente un schéma général par blocs du dispositif de reconstitution du signal,
la figure 2 représente le schéma du processeur analogique,
la figure 3 représente le schéma du circuit de traitement du processeur analogique dans sa conception générale,
les figures 4, 5 et 6 représentent les schémas des circuits de traitement du processeur analogique pour des choix particuliers des fonctions de reconstitution.
Le traitement du signal analogique E(t) s'effectue sur une période T1 d'acquisition des données, suivie d'une période T2 de traitement desdites données, la période T2 étant généralement plus longue que la période T1. La période T1 d'acquisition se décompose en un certain nombre de périodes τ d'analyse pour chacune desquelles se déroule le procédé décrit ci-après. A l'issue de la période T1 un certain nombre de données se trouvent mises en mémoire puis traitées pendant la période T2 de traitement, à l'issue de laquelle un ensemble de résultats calculés sont disponibles pour être visualisés et/ou traités pendant que les mêmes processus d'acquisition puis de traitement se renouvellent.
Le procédé selon l'invention consiste à représenter le signal reconstitué calculé S(t) sous la forme d'une somme de produits de k coefficients $S_k$ par k fonctions du temps $f_k(t)$:

(1) $S(t) = S_k \cdot f_k(t)$.

Le choix des k fonctions $f_k(t)$ n'est pas arbitraire. En effet, le signal analogique E(t), que l'on reconstitue par S(t), peut se décomposer en un spectre de fréquence allant de fréquences basses à des fréquences très élevées. Pour reconstituer le signal analogique E(t) il apparaît évident que les fonctions $f_k(t)$ choisies vont devoir permettre de reconstituer au mieux et à la fois toutes ces particularités du spectre de fréquences du signal analogique E(t). En fonction de l'application recherchée l'homme de l'art va donc, au départ ou par essais limités successifs, définir le nombre et le type de fonctions $f_k(t)$ qui conviennent le mieux afin que la bande passante du signal reconstitué calculé S(t) soit le mieux possible adaptée au signal analogique E(t).

3

Le choix des fonctions $f_k(t)$ est guidé par le fait qu'une combinaison linéaire de celles-ci doit pouvoir approximer la portion du signal E(t) comprise dans l'intervalle de temps $\tau$. Le choix, ainsi que le nombre k de fonctions $f_k(t)$ est donc lié au signal E(t). Une méthode connue d'approximation d'une fonction E(t) est le développement limité de E(t) en des polynômes en $\underline{t}$ de degré croissant. Une combinaison linéaire de $(\alpha+2)$ polynômes de degré allant de 0 à $(\alpha+1)$ peut approximer toute portion de sinusoïde, jusqu'à avoir $\alpha$ demi-sinusoïdes dans l'intervalle d'approximation.

Ainsi avec $\alpha = 2$ on a k $= \alpha+2 = 4$ polynômes de degré compris entre 0 et 3, et il est possible d'approximer deux demi-sinusoïdes c'est-à-dire une sinusoïde complète.

Avec $\alpha = 5$ on a k $= \alpha+2 = 7$ polynômes de degré compris entre 0 et 6, et il est possible d'approximer six demi-sinusoïdes c'est-à-dire trois périodes complètes de sinusoïde.

Ainsi un choix de fonctions $f_k(t)$ peut être une telle suite de polynômes.

Si le signal E(t) possède un spectre s'étendant de 0 à $\alpha$ fois la fréquence de Shannon, c'est-à-dire jusqu'à $\alpha$ demi-sinusoïdes par intervalle de temps $\tau$, en liaison avec ce qui précède on peut choisir $k=(\alpha+2)$, les fonctions $f_k(t)$ étant représentées par des polynômes de degré croissant allant de 0 à $\alpha+1$.

Ce choix étant fait il faut déterminer les coefficients $S_k$ permettant de calculer le signal reconstitué calculé S(t). pour cela le critère choisi est de minimiser la valeur de l'erreur quadratique moyenne entre le signal reconstitué calculé S(t) et le signal analogique E(t), soit:

$$(2) \quad <r^2> = <(E(t)-S(t))^2>$$

qui s'écrit:

$$(3) \quad <r^2> = <E^2(t)> + <S^2(t)> -2 \cdot S_k \cdot <E(t) \cdot f_k(t)>$$

En appliquant le critère choisi ci-dessus on calcule les coefficients $S_k$ qui minimisent cette erreur c'est-à-dire tels que:

$$(4) \quad \frac{\partial <r^2>}{\partial S_k} = 0.$$

On aboutit ainsi à une relation entre les coefficients $S_k$, les fonctions $f_k(t)$ et le signal analogique E(t) qui est:

$$(5) \quad S_k = M^{-1} \cdot <E(t) \cdot f_k(t)>$$

où $M^{-1}$ est l'inverse de la matrice M donnée par cette opération de minimisation par:

$$(6) \quad M = \begin{vmatrix} <f_1.f_1> & \ldots\ldots\ldots\ldots & <f_n.f_1> \\ & \cdot & \cdot \\ & \cdot & \cdot \\ <f_1.f_n> & \ldots\ldots\ldots\ldots & <f_n.f_n> \end{vmatrix}$$

où $f_1$ et $f_n$ représentent la première fonction $f_1(t)$ et la dernière fonction $f_n(t)$ des k fonctions $f_k(t)$.

Le critère de minimisation (équation 4) de la valeur de l'erreur quadratique moyenne (équation 2) définit le type de la matrice M qui est définie totalement par le choix des fonctions $f_k(t)$.

Le procédé nécessite l'acquisition des termes de moyennes $<E(t) \cdot f_k(t)>$.

Une première variante permettant d'effectuer cette acquisition est d'opérer les k multiplications du signal analogique E(t) par les k fonctions $f_k(t)$ et de calculer les k moyennes $<E(t) \cdot f_k(t)>$ pour chaque période $\tau$ d'analyse. On obtient ainsi les coefficients $S_k$ par l'équation (5). Le signal reconstitué calculé S(t) est obtenu en opérant la multiplication des k fonctions $f_k(t)$ par les k coefficients $S_k$ selon la relation (1).

Une seconde variante possédant une résolution accrue et une résolution simplifiée, et permettant d'effectuer l'acquisition des termes $<E(t) \cdot f_k(t)>$ consiste à introduire des fonctions $h_k(t)$ telles que:

$$(7) \quad h_k(t) = f_k(\tau-t).$$

Les k valeurs moyennes s'écrivent alors:

$$<E(t) \cdot f_k(t)> = <E(t) \cdot h_k(\tau-t)>.$$

Or le terme $<E(t) \cdot h_k(\tau-t)>$ représente le produit de convolution, sur la période $\tau$, de E(t) par les fonctions $h_k(t)$, c'est-à-dire la sortie d'un filtre recevant en entrée le signal E(t) et ayant une réponse impulsionnelle caractérisée par les fonctions $h_k(t)$. On en déduit ainsi que les k termes recherchés $<E(t) \cdot f_k(t)>$ sont les valeurs obtenues, à la fin de la période d'analyse $\tau$, aux k sorties du filtre caractérisé ci-dessus; ceci à la condition d'effectuer la remise à zéro de ces k sorties au début de chaque période d'analyse $\tau$, ce qui revient à définir pour ces k sorties des niveaux de tension qui correspondent à un signal d'entrée E(t) nul. Cet état peut être appelé état de repos du filtre.

L'invention est donc également remarquable en ce que les k moyennes $<E(t) \cdot f_k(t)>$ sont obtenues sur une période d'analyse $\tau$, en déterminant les k moyennes $<E(t) \cdot h_k(\tau\text{-}t)>$ par une opération de filtrage de réponse impulsionnelle $h_k(t) = f_k(\tau\text{-}t)$.

Les fonctions $f_k(t)$ étant choisies, l'équation (7) permet de définir le filtre à utiliser.

Une possibilité particulière de cette seconde variante peut apparaître pour laquelle il n'est pas nécessaire d'avoir à effectuer les remises à zéro précédentes. Ceci se présente lorsque les fonctons $h_k(t)$ obtenues précédemment peuvent s'écrire en faisant intervenir une matrice constante C:

(8) $h_k(\tau+x) = C \cdot h_k(x)$ (x: variable quelconque).

En effet considérons pour cela la période d'analyse comprise entre deux périodes d'analyse consécutives $N\tau$ et $(N+1)\tau$. Aux sorties du filtre de réponse impulsionnelle $h_k(t)$, on obtient à l'instant $N\tau$ les signaux XN tels que:

$$X_N = {}_0\!\int^{N\tau} E(t) \cdot h_k(N\tau\text{-}t)dt.$$

De même à l'instant consécutif suivant on a:

$$X_{N+1} = {}_0\!\int^{(N+1)\tau} E(t) \cdot h_k((N+1)\tau\text{-}t)dt.$$

Or en utilisant la relation (8) on peut écrire:

$$X_{N+1} = C \cdot {}_0\!\int^{N\tau} E(t) \cdot h_k(N\tau\text{-}t) + {}_{N\tau}\!\int^{(N+1)\tau} E(t) \cdot h_k((N+1)\tau\text{-}t)dt$$

que l'on peut écrire:

$$X_{N+1} = C \cdot X_N + {}_0\!\int^{\tau} E(N\tau+t) \cdot h_k(\tau\text{-}t)dt$$

soit plus généralement:

(9) $X_{N+1} = C \cdot X_N + <E(t) \cdot f_k(t)>.$

Cette dernière relation montre donc que les termes recherchés $<E(t) \cdot f_k(t)>$ peuvent être obtenus à l'aide des valeurs de signal $X_N$ et $X_{N+1}$ obtenues aux sorties du filtre de réponse impulsionnelle $h_k(t)$ sans qu'il soit nécessaire de remettre à zéro les sorties dudit filtre si la relation (8) est respectée.

L'invention est également remarquable en ce que les fonctions $h_k(t)$ sont les fonctions $h_k(\tau+x) = C \cdot h_k(x)$, x étant une variable quelconque, C une matrice de coefficients, de sorte que les k valeurs moyennes $<E(t) \cdot f_k(t)>$ s'obtiennent par:

$$<E(t) \cdot f_k(t)> = X_{N+1}\text{-}C \cdot X_N$$

avec

$$X_N = {}_0\!\int^{N\tau} E(t) \cdot h_k(N\tau\text{-}t)$$

et

$$X_{N+1} = {}_0\!\int^{(N+1)\tau} E(t) \cdot h_k((N+1)\tau\text{-}t)$$

N étant un entier, $X_N$ et $X_{N+1}$ étant les résultats obtenus après l'opération de filtrage à l'issue des temps respectifs $N\tau$ et $(N+1)\tau$.

Comme précédemment, l'équation (5) permet de déterminer les coefficients $S_k$. Le signal reconstitué calculé S(t) est obtenu en opérant la multiplication des k fonctions $f_k(t)$ par les k coefficients $S_k$ selon la relation (1).

Ce signal reconstitué calculé S(t) doit alors être comparé au signal analogique E(t) afin de décider de son utilisation sur la base d'un critère de choix de représentation. On définit ainsi des fonctions d'erreur caractérisant l'écart entre le signal reconstitué calculé S(t) et le signal analogique E(t). Selon une ou plusieurs bornes choisies pour chaque fonction d'erreur, et selon que ces fonctions d'erreur sont inférieures, supérieures ou comprises entre lesdites bornes pendant une période de durée déterminée, on définit le critère de choix de représentation imposant le mode de visualisation désiré. Ces fonctions d'erreurs peuvent être utilisées seules ou en combinaison.

Dans ce but la fonction d'erreur peut être constituée des valeurs de l'erreur quadratique moyenne $<r^2>$ tel que:

$$< r^2 > = < (E(t) - S(t))^2 >.$$

Pour cela il faut selon la relation (3) calculer la valeur quadratique moyenne du signal analogique $<E^2(t)>$, celle du signal reconstitué calculé $<S^2(t)>$, et le terme $2 \cdot S_k \cdot <E(t) \cdot f_k(t)>$ où tous les termes sont alors déterminés. Il est évident que si le signal analogique E(t) a peu varié durant la période $\tau$ d'analyse la valeur de $<r^2>$ sera faible. Par contre elle sera élevée si le signal a beaucoup varié durant ladite période $\tau$ d'analyse.

Egalement dans ce but la fonction d'erreur peut être celle définie par respectivement l'écart entre le maximum et le minimum du signal reconstitué calculé S(t) et les valeurs d'un gabarit constitué des valeurs maximale SUP et minimale INF du signal analogique E(t) déterminées pour chaque période $\tau$ d'analyse. Ainsi en appelant SUP (S(t)) et INF (S(t)) respectivement le maximum et le minimum de S(t) durant une période $\tau$ d'analyse, la fonction d'erreur est alors constituée du couple de valeurs (A, B) telles que:

$$A = | SUP - SUP (S(t)) |$$

$$B = | INF - INF (S(t)) |$$

La fonction d'erreur (A, B) peut alors être comparée à un couple de bornes $(B_1, B_2)$, |borne 1, borne 2|.

Bien évidemment un autre choix de fonction d'erreur peut être fait pour comparer le signal reconstitué calculé S(t) et le signal analogique E(t) sans sortir du but de l'invention.

A titre d'exemple non limitatif on peut choisir d'utiliser en combinaison la fonction d'erreur constituée de ladite erreur quadratique moyenne $<r^2>$, et ladite fonction d'erreur (A, B). Ainsi, lorsque à l'issue des étapes précédentes du procédé, on vérifie que l'erreur quadratique moyenne $<r^2>$ est supérieure à une borne $B_0$, par exemple 5 % du carré de l'excursion totale du signal à reconstituer E(t), on choisit d'affecter au signal reconstitué utile X(t) les valeurs maximale SUP et minimale INF du signal analogique E(t), soit une représentation en mode enveloppe.

Au contraire si l'erreur quadratique moyenne $<r^2>$ est inférieure à la borne $B_0$ on effectue le test de la fonction d'erreur (A, B). Si la fonction d'erreur (A, B) est inférieure au couple de bornes $(B_1, B_2)$ c'est-à-dire si on a à la fois $A < B_1$ et $B < B_2$ on affecte au signal reconstitué utile X(t) les valeurs du signal reconstitué calculé S(t), soit une représentation en mode signal.

Dans le cas contraire, c'est-à-dire si A ou B est supérieur à sa propre borne, on affecte au signal reconstitué utile X(t) les valeurs maximale SUP et minimale INF du signal analogique E(t), soit une représentation en mode enveloppe.

Le tableau 1 résume les choix opérés par période $\tau$ d'analyse dans le cas de set exemple non limitatif où l'on combine la fonction d'erreur quadratique moyenne $<r^2>$ avec la fonction d'erreur (A, B).

**Tableau 1**

| | | |
|---|---|---|
| $r^2 \geqslant B_0$ | | X(t) = (SUP, INF) |
| | $A < B_1$ et $B < B_2$ | X(t) = S(t) |
| $r^2 < B_0$ | | |
| | $A > B_1$ ou $B > B_2$ | X(t) = (SUP, INF) |

D'une façon générale le mode signal est utilisé lorsque ses deux tests réussissent. Dans le cas où il échouent on utilise le mode enveloppe.

Bien évidemment, d'autres critères de choix peuvent être effectués sans sortir du but de l'invention.

A l'issue de ces test, on peut alors choisir de représenter sur un écran d'oscilloscope deux traces dont l'une suit S(t) et INF et l'autre suit S(t) et SUP, le choix du passage du mode signal au mode enveloppe se faisant automatiquement par le système. Dans le cas du mode signal on obtient deux traces S(t) superposées et dans le cas du mode enveloppe deux traces disjointes représentant les valeurs SUP et INF et ceci pour chaque période $\tau$ d'analyse.

L'invention est ainsi remarquable en se que le choix du mode de représentation du signal reconstitué utile X(t), c'est-à-dire le mode enveloppe et/ou le mode signal, est fait automatiquement par période $\tau$ d'analyse selon une ou plusieurs bornes définies respectivement pour chaque fonction d'erreur, en fonction de la précision recherchée pour le signal reconstitué utile X(t), ledit choix étant fait en considérant les fonctions d'erreur soit indépendamment soit en combinaison entre elles.

Les valeurs de l'erreur quadratique moyenne $<r^2>$ et/ou de la fonction d'erreur (A,B), qui ont présidé au choix automatique du système, sont également visualisées de sorte que l'utilisateur peut estimer la qualité de la restitution fournie par l'oscilloscope.

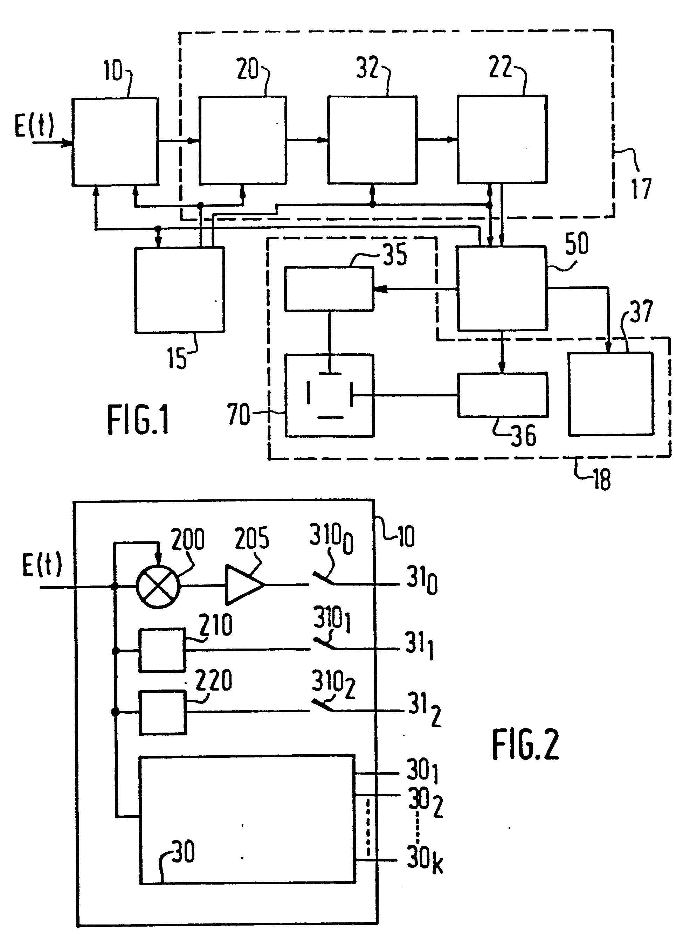

La figure 1 représente un schéma par blocs du dispositif de reconstitution du signal analogique E(t).

Le signal E(t) entre dans le processeur analogique 10 dont les sorties entrent dans un organe de mémorisation et de numérisation 17 dont les sorties entrent dans le dispositif de calcul et de test 50, qui délivre des signaux à l'organe de visualisation et/ou de traitement 18. Un cadenceur 15 fournit le cadencement contrôlé par le dispositif de calcul et de test 50 qui délivre des signaux de remise à zéro au processeur analogique 10.

L'organe de mémorisation et de numérisation 17 est constitué d'une mémoire analogique 20, fonctionnant à la même cadence que le processeur analogique 10, suivie, mais avec un fonctionnement à cadence plus lente, d'un convertisseur analogique-numérique 32 fournissant des informations stockées dans une mémoire numérique 22 (figure 1).

Selon la vitesse d'exécution demandée au dispositif de reconstitution du signal, la mémoire analogique 20 peut être supprimée, l'organe de mémorisation et de numérisation 17 étant alors constitué du convertisseur analogique-numérique 32 et de la mémoire numérique 22 fonctionnant à la cadence du processeur analogique 10.

L'organe de visualisation et/ou de traitement 18 est constitué:

a) d'un organe de traitement 37 qui exploite les informations relatives au signal reconstitué utile X(t) et aux signaux de fonctions d'erreur;

b) de moyens de visualisation constitués d'un dispositif de visualisation 70 recevant les signaux issus d'un premier convertisseur numérique-analogique 35 traitant les mêmes dites informations, et celles issues d'un second convertisseur numérique-analogique 36 traitant les signaux de synchronisation et de cadence lente.

Le processeur analogique 10 représenté sur la figure 2 permet de déterminer le signal reconstitué calculé S(t) et concerne les cas où les valeurs maximales SUP et minimale INF et la valeur de $E^2(t)$ doivent être déterminées. Dans le cas où la fonction d'erreur est l'erreur quadratique moyenne, le signal analogique E(t) entre dans un élévateur au carré 200 qui fournit le signal $E^2(t)$ qui entre dans un intégrateur de signal 205 dont la sortie entre dans un premier dispositif d'échantillonnage $310_0$.

Dans le cas où les valeurs SUP(S(t)) et INF(S(t)) sont comparées à un gabarit, le signal analogique E(t) entre dans deux détecteurs de crête 210, 220 donnant respectivement les valeurs maximale SUP et minimale INF prises par le signal analogique E(t) durant la période $\tau$ d'analyse bornes comprises. Ces signaux SUP et INF entrent respectivement dans un deuxième $310_1$ et un troisième dispositif d'échantillonnage $310_2$. Le gabarit obtenu est destiné à encadrer les valeurs maximale SUP(S(t)) et minimale INF(S(t)) du signal reconstitué calculé S(t) afin de permettre le choix du mode de représentation.

Le signal analogique E(t) entre également dans le circuit de traitement 30. Le processeur analogique 10 délivre les signaux de sortie $31_0$ à $31_2$ et $30_1$ à $30_k$ qui pénètrent dans l'organe de mémorisation et de numérisation 17.

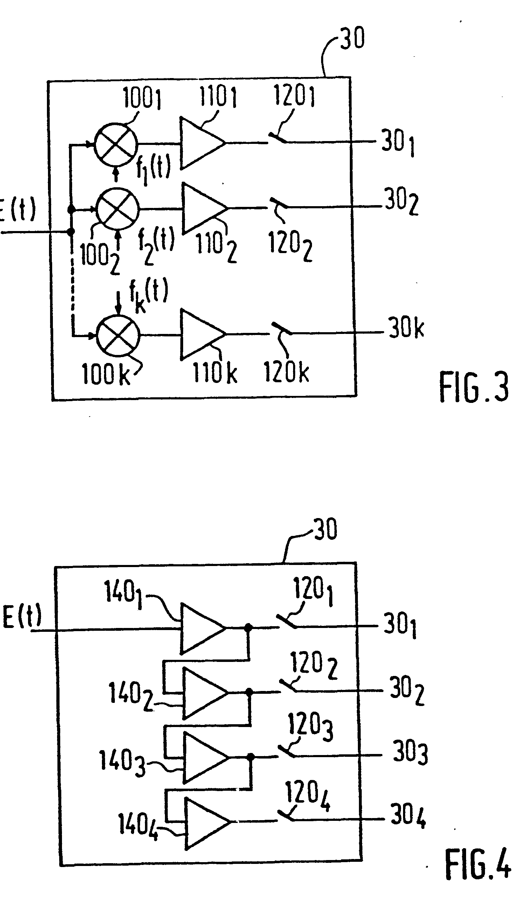

Selon la première variante, le circuit de traitement 30 (figure 3) est composé de k circuits élémentaires opérant un traitement semblable pour les k fonctions choisies. Le premier circuit élémentaire est constitué du multiplieur $100_1$ qui reçoit sur ses entrées le signal analogique E(t) et la première fonction choisie $f_1(t)$. La sortie du multiplieur $100_1$ pénètre dans un premier dispositif d'intégration $110_1$ dont la sortie pénètre dans un premier échantillonneur $120_1$. Ce circuit élémentaire est répété k fois pour opérer un traitement identique avec les k fonctions choisies $f_k(t)$. En sortie du circuit de traitement 30 on dispose de k signaux $30_1$ à $30_k$.

Selon cette variante le circuit de traitement 30 qui opère le traitement du signal analogique E(t) par des fonctions $f_k(t)$ liées à la bande passante du signal E(t), est constitué de k circuits de multiplication $100_1$ à $100_k$ du signal E(t) par les k fonctions $f_k(t)$, respectivement suivis de k dispositifs d'intégration $110_1$ à $110_k$, respectivement suivis de k échantillonneurs $120_1$ à $120_k$ dont les k sorties $30_1$ à $30_k$ sont réunies aux entrées de l'organe de mémorisation et de numérisation 17.

Dans un mode particulier de réalisation, si on désire approximer des signaux dont la bande passante s'étend jusqu'à 2 fois la fréquence de Shannon à partir d'une combinaison linéaire de polynômes, on doit utiliser 4 polynômes de degré 0, 1, 2, 3 pour les fonctions $f_k(t)$. Avantageusement, pour mieux correspondre aux signaux à traiter en oscilloscopie, en respectant la règle de choix précédemment décrite, les fonctions $f_k(t)$ sont choisies du type $f_n(t) = n(1-t)n^{-1}$. Les quatre fonctions sont alors:

$$f_1(t) = 1; f_2(t) = 2(1-t); f_3(t) = 3(1-t)^2; f_4(t) = 4(1-t)^3.$$

Par une combinaison appropriée de ces fonctions on peut approcher correctement la reconstitution des courbes de signaux ayant des variations linéaire, parabolique, sinusoïdale ou constante avec le temps permettant de reconstituer des formes de signaux usuels.

Avec un autre choix de type de fonctions des formes complexes peuvent être reconstituées conduisant à une possibilité d'adapter la bande passante du signal reconstitué à la bande passante du signal d'entrée.

Dans le cas où l'on choisit des fonctions du type:

$$f_n(t) = n(1-t)n^{-1}$$

le terme générique $<f_i \cdot f_j>$ de ligne i et de colonne j de la matrice (6) s'écrit:

$$<f_i \cdot f_j> = \frac{ij}{i+j-1}$$

7

et dans le cas choisi limité à 4 fonctions la matrice s'écrit:

$$M = \begin{vmatrix} 1 & 1 & 1 & 1 \\ 1 & 4/3 & 3/2 & 8/5 \\ 1 & 3/2 & 9/5 & 2 \\ 1 & 8/5 & 2 & 16/7 \end{vmatrix}$$

Ce choix offre par ailleurs l'avantage que les déterminations des valeurs moyennes $<E(t) \cdot f_k(t)>$, conformes au procédé selon l'invention, se déduisent les unes des autres par récurrence permettant une réalisation expérimentale simple.

Ainsi après un développement mathématique classique, ce choix permet d'écrire, pour chaque période $\tau$ d'analyse:

$$\begin{aligned}
<E(t) \cdot f_1(t)> &= <E(t) \cdot 1> &&= -P_1(\tau) \\
<E(t) \cdot f_2(t)> &= <E(t) \cdot 2(1-t)> &&= P_2(\tau) \\
<E(t) \cdot f_3(t)> &= <E(t) \cdot 3(1-t)^2> &&= -P_3(\tau) \\
<E(t) \cdot f_4(t)> &= <E(t) \cdot 4(1-t)^3> &&= P_4(\tau)
\end{aligned}$$

avec les fonctions $P_n(t)$ reliées entre elles par la relation:

$$P_n(t) = -n \int_0^t P_{n-1}$$

Ceci indique que le terme $P_n(t)$ d'ordre n est défine en déterminant la valeur moyenne du terme précédent $P_{n-1}$, cette moyenne devant être multipliée par l'ordre n du terme $P_n(t)$. Dans le dispositif selon l'invention, ces moyennes sont calculées à l'aide d'intégrateurs mis en série, dont les gains en valeur absolue sont respectivement égaux à leur ordre n.

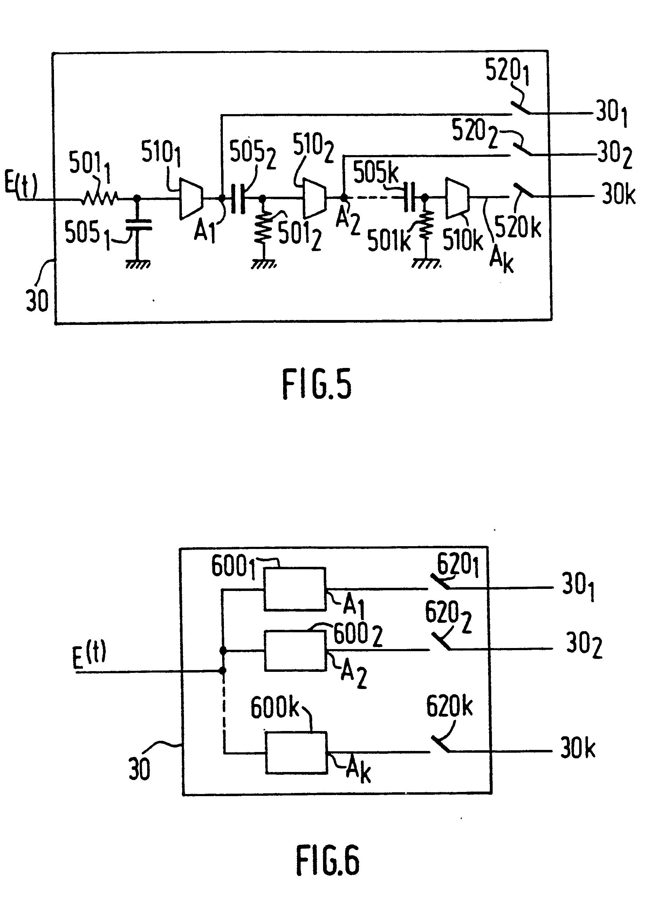

Pour chaque période $\tau$ d'analyse, la détermination des valeurs $P_1(\tau)$, $P_2(\tau)$, $P_3(\tau)$, $P_4(\tau)$, se fait à l'aide du circuit de traitement 30 représenté sur la figure 4. Les quatre intégrateurs de gain -n $140_1$ à $140_4$ sont reliés en série, le signal analogique $E(t)$ entrant dans le premier intégrateur $140_1$. Les sorties des quatre intégrateurs correspondant aux quatre signaux $P_1(\tau)$, $P_2(\tau)$, $P_3(\tau)$, $P_4(\tau)$, sont reliées individuellement à quatre échantillonneurs $120_1$ à $120_4$, le circuit de traitement 30 délivrant quatre signaux $30_1$ à $30_4$ reliés à l'organe de mémorisation et de numérisation 17.

Selon ce mode particulier, le circuit de traitement 30 qui opère le traitement du signal analogique $E(t)$ par des fonctions $f_k(t)$ liées à la bande passante du signal $E(t)$, telles que $f_n(t) = n(1-t)^{n-1}$ pour lesquelles les produits $<E(t) \cdot f_k(t)>$ s'écrivent $<E(t) \cdot f_n(t)> = P_n(t) = -n<P_{n-1}(t)>$, $n \in |1,k|$, ledit circuit de traitement est constitué de k intégrateurs $140_1$, $140_k$ opérant sur une période d'analyse $\tau$, le premier intégrateur $140_1$ ayant un gain -1 et le k ième $140_k$ ayant un gain -k, connectés en série, et également réunis en sortie chacun à k échantillonneurs $120_1$ à $120_k$ dont les k sorties sont réunies aux entrées d'un organe de mémorisation et de numérisation 17.

D'autre part les dispositifs d'intégration $110_1$ à $110_k$ ou les intégrateurs $140_1$ à $140_4$ sont considérés être des intégrateurs parfaits c'est-à-dire pour lesquels la réponse impulsionnelle est pratiquement rectangulaire. Mais sans perdre de sa généralité le procédé et le dispositif peuvent utiliser des intégrateurs imparfaits tels que des intégrateurs à résistance-capacité. Dans ce cas, au lieu de la valeur moyenne du signal on obtient à la sortie de l'intégrateur, par exemple avec $f_1(t) = 1$:

$$\int_0^\tau E(t) \cdot e^{(-1+t)/\tau 1}$$

où $\tau_1$ est la constante de temps de l'intégrateur R-C.

Il va de soi que le nombre et le type des fonctions choisies ne saurait limiter l'invention, celles-ci étant choisies par l'homme de l'art selon l'application envisagée.

Selon la seconde variante correspondant aux filtres de réponse impulsionnelle $h_k(t)$ précédemment définis à partir de l'équation (7), il est possible de réaliser le circuit de traitement 30 de deux manières différentes:
- une première manière (figure 5) est constituée d'un filtre de réponse impulsionnelle $h_k(t)$ possédant une entrée recevant le signal analogique $E(t)$, formé par la mise en série de k étages élémentaires de filtrage définis de telle sorte que vu à partir des sorties $A_1$, $A_2$,..., $A_k$, le filtre présente des transmittances respectivement égales à $h_1(t)$, $h_2(t)$,..., $h_k(t)$. Le premier étage comprend un intégrateur, le signal $E(t)$ arrivant sur une résistance $501_1$ dont l'autre extrémité est réunie à la masse par une capacité $505_1$ et à un adaptateur d'impédances $510_1$ dont le rôle n'est que d'éviter à l'étage qui le suit d'intervenir en amont. Le second étage comprend un différentiateur, la sortie $A_1$ de l'adaptateur d'impédances $510_1$ étant reliée à une capacité $505_2$

dont l'autre extrémité est reliée à la masse par une résistance $501_2$ et à un adaptateur d'impédances $510_2$ ayant une sortie $A_2$. Le second étage est ainsi répété k fois avec une structure identique de différentiateur. Les k sorties $A_1$, $A_2$,..., $A_k$ sont réunies à k échantillonneurs $520_1$, $520_2$,..., $520_k$ qui délivrent k signaux $30_1$, $30_2$,..., $30_k$ en sortie du circuit de traitement 30.

- Une seconde manière (figure 6) de réaliser cette même seconde variante est de disposer les k étages élémentaires de filtrage en parallèle. Le signal analogique E(t) arrive à l'entrée des k étages élémentaires de filtrage $600_1$ à $600_k$ de réponse impulsionnelle $h_1(t)$,..., $h_k(t)$, dont les k sorties sont réunies à k échantillonneurs $620_1$ à $620_k$ qui délivrent k signaux $30_1$ à $30_k$ en sortie du circuit de traitement 30. Cette seconde manière présente l'avantage que le k étages élémentaires de filtrage peuvent être réglés indépendamment.

Selon cette variante le circuit de traitement 30 qui opère le traitement du signal analogique E(t) par des fonctions $f_k(t)$ liées à la bande passante du signal E(t), est constitué par la mise en série ($501_1$, $505_1$, $510_1$) à ($501_k$, $505_k$, $510_k$) ou la mise en parallèle $600_1$ à $600_k$ de k étages élémentaires de filtrage, ayant respectivement pour sorties $A_1$... $A_k$, et respectivement en ces sorties des transmittances $h_1(t)$...$h_k(t)$, telles que $h_k(t) = f_k(\tau-t)$, les sorties $A_1$... $A_k$ étant réunies à k échantillonneurs $520_1$ à $520_k$, $620_1$ à $620_k$ opérant sur la période $\tau$ d'analyse dont les k sorties sont réunies aux entrées de l'organe de mémorisation et de numérisation 17.

Il est bien évident que dans la première manière (montage en série) ou dans la seconde manière (montage en parallèle), les étages élémentaires de filtrage constitués d'intégrateurs ou de différentiateurs ou de filtres à bande passante particulière, peuvent se succéder dans un ordre autre que celui qui vient d'être indiqué sans sortir du domaine de l'invention.

Le processeur analogique 10 effectue l'acquisition des informations durant la période T1 pour chaque période $\tau$ d'analyse. Dans le cas cité où l'on utilise la mémoire analogique 20 (figure 1), les informations y sont stockées à chaque période $\tau$ d'analyse. Elles sont ensuite numérisées puis stockées dans la mémoire numérique au cours de la période T2. Dans le cas contraire les informations issues du processeur analogique 10 sont directement numérisées par le convertisseur analogique-numérique 32 puis stockées dans la mémoire numériques 22 et ceci pendant la période T1 d'acquisition.

A l'issue de cette période, le traitement des informations stockées est effectué selon les équations 1 à 5, puis les résultats testés dans le dispositif de calcul et de test 50 au cours de la période T2. A l'issue de ces opérations les données utiles sont ensuite restituées, à une cadence lente et visualisées par le dispositif de visualisation 70 pendant que simultanément se renouvellent les opérations d'acquisition et de traitement relatives aux périodes T1 et T2.

Le dispositif de calcul et de test 50 délivre, outre des signaux de synchronisation et de cadencement pour la visualisation, le signal reconstitué utile X(t) et/ou le signal d'erreur quadratique moyenne $<r^2>$ et/ou le signal représentant la fonction d'erreur (A, B). Les valeurs de l'erreur quadratique moyenne $<r^2>$ sont comparées à une borne préalablement définie. Si le signal a peu varié, $<r^2>$ est inférieur à la borne et le second test est opéré sur la fonction d'erreur (A, B). Si A et B sont inférieurs à leurs bornes respectives ($B_1$, $B_2$), le dispositif de calcul et de test 50 restitue automatiquement le signal reconstitué calculé S(t) c'est-à-dire le mode signal. Si A ou B sont supérieurs à leurs bornes respectives (B1, B2), le dispositif de calcul et de test 50 restitue automatiquement les valeurs SUP et INF, c'est-à-dire le mode enveloppe. Si le signal a beaucoup varié, $<r^2>$ est supérieur à la borne et le dispositif de calcul et de test 50 restitue automatiquement et simultanément les valeurs SUP et INF déterminées, ce qui correspond au mode enveloppe. Dans les deux modes le dispositif affiche la valeur de l'erreur quadratique moyenne $<r^2>$ calculée et/ou la fonction d'erreur (A, B), fournissant ainsi une indication de l'erreur commise dans le choix effectué, ce qui autorise toute intervention manuelle.

La mémoire analogique 20, qui stocke les informations analogiques est avantageusement un dispositif à transfert de charges.

## Revendications

1. Procédé de reconstitution d'un signal analogique E(t) sous la forme d'un signal numérique reconstitué utile X(t), destiné à être séquentiellement visualisé et/ou traité, formé par période $\tau$ d'analyse, soit des échantillons d'un signal reconstitué calculé S(t) restitués dans le mode de représentation signal, soit des valeurs minimale et maximale du signal analogique E(t) restituées dans le mode de représentation enveloppe, caractérisé en ce qu'il comprend les étapes suivantes:
- multiplication du signal analogique E(t) séparément par k fonctions du temps $f_k(t)$ pour obtenir k produits E(t) · $f_k(t)$, et calcul de leurs moyennes respectives pour obtenir k moyennes $<E(t) \cdot f_k(t)>$ à l'issue de chaque période $\tau$ d'analyse, les fonctions $f_k(t)$ étant choisies de sorte que la bande passante qu'elles couvrent soit adaptée à la bande passante du signal analogique E(t);
- détermination des k coefficients $S_k$ par $S_k = M^{-1} \cdot <E(t) \cdot f_k(t)>$ où $M^{-1}$ est l'inverse de la matrice M telle que

$$M = \begin{vmatrix} \langle f_1 . f_1 \rangle & \dots\dots\dots\dots & \langle f_n . f_1 \rangle \\ & . & \quad . \\ & . & \quad . \\ \langle f_1 . f_n \rangle & \dots\dots\dots\dots & \langle f_n . f_n \rangle \end{vmatrix}$$

où $f_1$ et $f_n$ représentent respectivement la première fonction $f_1(t)$ et la dernière fonction $f_n(t)$ des k fonctions $f_k(t)$,
- détermination du signal reconstitué calculé S(t) par:

$$S(t) = S_k \cdot f_k(t);$$

- sélection du mode de représentation enveloppe ou signal, selon un critère de choix de représentation, basé sur au moins une fonction d'erreur déterminée entre le signal reconstitué calculé S(t) et le signal analogique E(t);
- visualisation et/ou traitement du signal reconstitué utile X(t).

2. Procédé de reconstitution d'un signal analogique E(t) selon la revendication 1, caractérisé en ce que les k moyennes $<E(t) \cdot f_k(t)>$ sont obtenues sur une période d'analyse $\tau$, en déterminant les k moyennes $<E(t) \cdot h_k(\tau\text{-}t)>$ par une opération de filtrage de réponse impulsionnelle $h_k(t) = f_k(\tau\text{-}t)$.

3. Procédé de reconstitution d'un signal analogique E(t) selon la revendication 2, caractérisé en ce que les fonctions $h_k(t)$ sont les fonctions $h_k(\tau+x) = C \cdot h_k(x)$, x étant une variable quelconque, C une matrice de coefficients, de sorte que les k valeurs moyennes $<E(t) \cdot f_k(t)>$ s'obtiennent par:

$$<E(t) \cdot f_k(t)> = X_{N+1}\text{-}C \cdot X_N$$

avec

$$X_N = {}_0\!\int^{N\tau} E(t) \cdot h_k(N\tau\text{-}t)$$

et

$$X_{N+1} = {}_0\!\int^{(N+1)\tau} E(t) \cdot h_k((N+1)\tau\text{-}t)$$

N étant un entier, $X_N$ et $X_{N+1}$ étant les résultats obtenus après l'opération de filtrage à l'issue des temps respectifs $N\tau$ et $(N+1)\tau$.

4. Procédé de reconstitution d'un signal analogique E(t) selon la revendication 1, caractérisé en ce que les fonctions du temps $f_k(t)$ sont du type $f_n(t) = n \cdot (1\text{-}t)^{n-1}$.

5. Procédé de reconstitution d'un signal analogique E(t) selon la revendication 4, caractérisé en ce que les fonctions $f_k(t)$ sont au nombre de quatre:

$$f_1(t) = 1; \; f_2(t) = 2(1\text{-}t); \; f_3(t) = 3(1\text{-}t)^2; \; f_4(t) = 4(1\text{-}t)^3.$$

6. Procédé de reconstitution d'un signal analogique E(t) selon une des revendications 1 à 5, caractérisé en ce qu'une des fonctions d'erreur est définie par la valeur de l'erreur quadratique moyenne: $<r^2> = <(E(t) - S(t))^2>$

7. Procédé de reconstitution d'un signal analogique E(t) selon une des revendications 1 à 6, caractérisé en ce qu'une des fonctions d'erreur est definie par respectivement l'écart entre le maximum et le minimum du signal reconstitué calculé S(t) et les valeurs d'un gabarit constitué des valeurs maximale (SUP) et minimale (INF) du signal analogique E(t) déterminées pour chaque période $\tau$ d'analyse.

8. Procédé de reconstitution d'un signal analogique E(t) selon la revendication 6, caractérisé en ce qu'il comprend une détermination de la valeur quadratique moyenne du signal analogique E(t).

9. Procédé de reconstitution d'un signal analogique E(t) selon une des revendications précédentes, caractérisé en ce que le choix du mode de représentation du signal reconstitué utile X(t), c'est-à-dire le mode enveloppe et/ou le mode signal, est fait automatiquement par période $\tau$ d'analyse selon une ou plusieurs bornes définies respectivement pour chaque fonction d'erreur, en fonction de la précision recherchée pour le signal reconstitué utile X(t), ledit choix étant fait en considérant les fonctions d'erreur soit indépendamment soit en combinaison entre elles.

10. Procédé de reconstitution d'un signal analogique E(t) selon une des revendications précédentes caractérisé en ce que l'on effectue, en outre, la visualisation et/ou le traitement ultérieur d'au moins une fonction d'erreur.

11. Dispositif d'obtention d'un signal reconstitué utile X(t) à partir d'un signal analogique E(t) pour la mise en oeuvre du procédé selon une des revendications 1 à 10, signal X(t) destiné à être séquentiellement visualisé et/ou traité, formé par période τ d'analyse, soit des échantillons d'un signal reconstitué calculé S(t) restitués dans le mode de représentation signal, soit des valeurs minimale et maximale du signal analogique E(t) restituées dans le mode de représentation enveloppe, caractérisé en ce que le signal analogique E(t) entre dans un processeur analogique (10) qui comprend:

- un circuit de traitement (30) opérant le traitement du signal analogique E(t) par des fonctions $f_k(t)$ adaptées à la bande passante du signal E(t), le circuit de traitement étant constitué de k circuits de multiplication ($100_1$ à $100_k$) du signal E(t) par les k fonctions $f_k(t)$, respectivement suivis de k dispositifs d'intégration ($110_1$ à $110_k$), respectivement suivis de k échantillonneurs ($120_1$ à $120_k$) dont les k sorties ($30_1$ à $30_k$) sont réunies aux entrées de l'organe de mémorisation et de numérisation (17)
- et des moyens de choix du mode de représentation basés sur au moins une fonction d'erreur caractérisant l'écart entre le signal reconstitué calculé S(t) et le signal analogique E(t), les sorties de l'organe de mémorisation et de numérisation entrant dans un dispositif de calcul et de test (50) qui fournit:
  a) à un organe de visualisation et/ou de traitement (18) des signaux de synchronisation et des signaux de cadence, ainsi que le signal reconstitué utile X(t) et éventuellement les signaux de la ou des fonctions d'erreur afin de permettre le choix du mode de représentation, pour chaque période τ d'analyse,
  b) des signaux de remise à zéro au processeur analogique (10) et des signaux de synchronisation à un cadenceur (15); celui-ci imposant les cadences de fonctionnement au processeur analogique (10) à l'organe de mémorisation et de numérisation (17) et au dispositif de calcul et de test (50).

12. Dispositif d'obtention d'un signal reconstitué utile X(t) à partir d'un signal analogique E(t) pour la mise en oeuvre du procédé selon une des revendications 1 à 10, signal X(t) destiné à être séquentiellement visualisé et/ou traité, formé par période τ d'analyse, soit des échantillons d'un signal reconstitué calculé S(t) restitués dans le mode de représentation signal, soit des valeurs minimale et maximale du signal analogique E(t) restituées dans le mode de représentation enveloppe, caractérisé en ce que le signal analogique E(t) entre dans un processeur analogique (10) qui comprend:

- un circuit de traitement (30) opérant le traitement du signal analogique E(t) par des fonctions $f_k(t)$ adaptées à la bande passante du signal E(t), le circuit de traitement étant constitué par la mise en série ($501_1$, $505_1$, $510_1$) à ($501_k$, $505_k$, $510_k$) ou la mise en parallèle ($600_1$ à $600_k$) de k étages élémentaires de filtrage, ayant respectivement pour sorties $A_1$... $A_k$, et respectivement en ces sorties des transmittances $h_1(t)$... $h_k(t)$, telles que $h_k(t) = f_k(\tau - t)$, les sorties $A_1$... $A_k$ étant réunies à k échantillonneurs ($520_1$ à $520_k$) ($620_1$ à $620_k$) opérant sur la période τ d'analyse dont les k sorties sont réunies aux entrées de l'organe de mémorisation et de numérisation (17),
- et des moyens de choix du mode de représentation basés sur au moins une fonction d'erreur caractérisant l'écart entre le signal reconstitué calculé S(t) et le signal analogique E(t), les sorties de l'organe de mémorisation et de numérisation entrant dans un dispositif de calcul et de test (50) qui fournit:
  a) à un organe de visualisation et/ou de traitement (18) des signaux de synchronisation et des signaux de cadence, ainsi que le signal reconstitué utile X(t) et éventuellement les signaux de la ou des fonctions d'erreur afin de permettre le choix du mode de représentation, pour chaque période τ d'analyse,
  b) des signaux de remise à zéro au processeur analogique (10) et des signaux de synchronisation à un cadenceur (15); celui-ci imposant les cadences de fonctionnement au processeur analogique (10) à l'organe de mémorisation et de numérisation (17) et au dispositif de calcul et de test (50).

13. Dispositif d'obtention d'un signal reconstitué utile X(t) à partir d'un signal analogique E(t) pour la mise en oeuvre du procédé selon une des revendications 1 à 10, signal X(t) destiné à être séquentiellement visualisé et/ou traité, formé par période τ d'analyse, soit des échantillons d'un signal reconstitué calculé S(t) restitués dans le mode de représentation signal, soit des valeurs minimale et maximale du signal analogique E(t) restituées dans le mode de représentation enveloppe, <u>caractérisé</u> en ce que le signal analogique E(t) entre dans un processeur analogique (10) qui comprend:

- un circuit de traitement (30) opérant le traitement du signal analogique E(t) par des fonctions $f_k(t)$ adaptées à la bande passante du signal E(t), telles que $f_n(t) = n(1-t)^{n-1}$, pour lesquelles les produits $<E(t) \cdot f_k(t)>$ s'écrivent $<E(t) \cdot f_n(t)> = p_n(t) = -n<P_{n-1}(t)>$, $n \in |1,k|$, le circuit de traitement étant constitué de k intégrateurs ($140_1$, $140_k$) opérant sur une période d'analyse τ, le premier intégrateur ($140_1$) ayant un gain -1 et le k ième ($140_k$) ayant un gain -k, connectés en série, et également réunis en sortie chacun à k échantillonneurs ($120_1$ à $120_k$) dont les k sorties sont réunies aux entrées d'un organe de mémorisation et de numérisation (17),
- et des moyens de choix du mode de représentation basés sur au moins une fonction d'erreur caractérisant l'écart entre le signal reconstitué calculé S(t) et le signal analogique E(t), les sorties de l'organe de mémorisation et de numérisation entrant dans un dispositif de calcul et de test (50) qui fournit:
  a) à un organe de visualisation et/ou de traitement (18) des signaux de synchronisation et des signaux de cadence, ainsi que le signal reconstitué utile X(t) et éventuellement les signaux de la ou des fonctions d'erreur afin de permettre le choix du mode de représentation, pour chaque période τ d'analyse,
  b) des signaux de remise à zéro au processeur analogique (10) et des signaux de synchronisation à un cadenceur (15); celui-ci imposant les cadences de fonctionnement au processeur analogique (10) à l'organe de mémorisation et de numérisation (17) et au dispositif de calcul et de test (50).

14. Dispositif d'obtention d'un signal reconstitué utile X(t) selon la revendication 13, caractérisé en ce que la variable k est égale à 4.

11

15. Dispositif d'obtention d'un signal reconstitué utile X(t) selon une des revendications 11 à 14, caractérisé en ce que le processeur analogique (10) comprend un élévateur au carré (200) du signal analogique E(t) dont la sortie entre dans un intégrateur de signal (205) suivi d'un premier dispositif d'échantillonnage $(310_0)$ dont la sortie est reliée au dipositif de calcul et de test (50) qui détermine l'erreur quadratique moyenne $<r^2>$ utilisée comme fonction d'erreur, et la compare à une borne Bo afin de permettre le choix du mode de représentation.

16. Dispositif d'obtention d'un signal reconstitué utile X(t) selon une des revendications 12 à 15, caractérisé en ce que le processeur analogique (10) comprend deux détecteurs de crête (210) (220) déterminant respectivement le maximum SUP et le minimum MIN du signal analogique E(t) durant la période $\tau$ d'analyse bornes comprises, lesdits détecteurs étant suivis respectivement d'un deuxième $(310_1)$ et d'un troisième $(310_2)$ dispositif d'échantillonnage, qui délivrent les valeurs maximale et minimale d'un gabarit qui doit encadrer les valeurs maximale SUP (S(t)) et minimale INF (S(t)) du signal reconstitué calculé S(t) afin de permettre le choix du mode de représentation.

17. Dispositif d'obtention d'un signal reconstitué utile X(t) selon les revendications 15 et 16, caractérisé en ce que le choix du mode de représentation s'effectue selon le tableau:

$r^2 \geqslant B_0 \qquad\qquad X(t) = (SUP, INF)$

$$r^2 < B_0 \quad \begin{cases} et & \begin{array}{l} A < B_1 \\ B < B_2 \end{array} & X(t) = S(t) \\ ou & \begin{array}{l} A > B_1 \\ B > B_2 \end{array} & X(t) = (SUP, INF) \end{cases}$$

où
$A = |SUP - SUP\ (S(t))|$
$B = |INF - INF\ (S(t))|$

et $B_1$ et $B_2$ étant des bornes d'erreur prédéterminées.

18. Dispositif d'obtention d'un signal reconstitué utile X(t) selon l'une des revendications 13 à 17, caractérisé en ce que les dispositifs d'intégration $(110_1$ à $110_k)$ et/ou les intégrateurs $(140_1$ à $140_k)$ et/ou l'intégrateur de signal (205) et/ou les étages élémentaires de filtrage $((501_1, 505_1, 510_1)$ à $(501_k, 505_k, 510_k)$ $(600_1$ à $600_k))$ sont constitués par des structures à résistance-capacité.

19. Dispositif d'obtention d'un signal reconstitué utile X(t) selon l'une des revendications 11 à 18, caractérisé en ce que l'organe de mémorisation et de numérisation (17) est constitué d'une mémoire analogique (20), d'un convertisseur analogique-numérique (32) et d'une mémoire numérique (22).

20. Dispositif d'obtention d'un signal reconstitué utile X(t) selon l'une des revendications 11 à 18, caractérisé en ce que l'organe de mémorisation et de numérisation (17) est constitué d'un convertisseur analogique-numérique (32) et d'une mémoire numérique (22).

21. Dispositif d'obtention d'un signal reconstitué utile X(t) selon la revendication 19, caractérisé en ce que la mémoire analogique (20) est un dispositif à transfert de charges.

22. Dispositif d'obtention d'un signal reconstitué utile X(t) selon l'une des revendications 11 à 21, caractérisé en ce que lesdits procédé et dispositif sont utilisés pour visualiser et/ou traiter dans un oscilloscope un signal reconstitué utile X(t).

23. Oscilloscope caractérisé en ce qu'il utilise un dispositif d'obtention d'un signal reconstitué utile X(t) selon l'une des revendications 12 à 22.

## Patentansprüche

1. Verfahren zur Wiedergewinnung eines Analogsignals E(t) in Form eines wiedergewonnenen numerischen Nutzsignals X(t), das zum sequentiellen Sichtbarmachen und/oder Bearbeiten bestimmt und dabei je Analysenzeit $\tau$ entweder aus im Signaldarstellungsbetrieb wiedergegebenen Signal-proben eines wiedergewonnenen berechneten Signals S(t) oder aus im Um-hüllenden-Darstellungsbetrieb wiedergegebenen ·minimalen und maximalen Werten des Analogsignals E(t) aufgebaut ist, dadurch gekennzeichnet, daß dieses Verfahren folgende Schritte umfaßt:
- Vervielfachung des Analogsignals E(t), getrennt durch k Zeitfunktionen $f_k(t)$ zum Erhalten von k Produkten $E(t) \cdot f_k(t)$, und Berechnung ihrer jeweiligen Mittelwerten zum Erhalten von k Mittelwerten $<E(t) \cdot f_k(t)>$ am Ende jeder Analysenzeit $\tau$, wobei die $f_k(t)$-Funktionen derart gewählt werden, daß das von ihnen belegte Durchlaßband an das Durchlaßband des Analogsignals E(t) angepaßt wird;
- Bestimmung der k Koeffizienten $S_k$, worin $S_k = M^{-1} \cdot <E(t) \cdot f_k(t)>$ ist, worin $M^{-1}$ die Kehrmatrix ist, so daß

$$M = \begin{vmatrix} \langle f_1 . f_1 \rangle \dots\dots\dots\dots\dots\dots \langle f_n . f_1 \rangle \\ \cdot \qquad\qquad\qquad\qquad \cdot \\ \cdot \qquad\qquad\qquad\qquad \cdot \\ \langle f_1 . f_n \rangle \dots\dots\dots\dots\dots\dots \langle f_n . f_n \rangle \end{vmatrix}$$

worin $f_1$ und $f_n$ die erste Funktion $f_1(t)$ bzw. die letzte Funktion $f_n(t)$ der k Funktionen $f_k(t)$ sind;
- Bestimmung des wiedergewonnenen Berechnungssignals S(t) ist, worin S(t) = $S_k \cdot f_k(t)$ ist;
- Wahl des Umhüllenden- oder Signaldarstellungsbetriebs gemäß einem Darstellungskriterium, das auf wenigstens einer bestimmten Fehlerfunktion zwischen dem wiedergewonnenen berechneten Signal S(t) und dem Analogsignal E(t) basiert;
- Sichtbarmachung und/oder Bearbeitung des wiedergewonnenen Nutzsignals X(t).

2. Verfahren zur Wiedergewinnung eines Analogsignals E(t) nach Anspruch 1, dadurch gekennzeichnet, daß die k Mittelwerte $\langle E(t) \cdot f_k(t) \rangle$ in einer Analysenperiode τ bei der Bestimmung der k Mittelwerte $\langle E(t) \cdot h_k(\tau - t) \rangle$ durch eine Stoßantwortfilterung $h_k(t) = f_k(\tau - t)$ erhalten werden.

3. Verfahren zur Wiedergewinnung eines Analogsignals E(t) nach Anspruch 2, dadurch gekennzeichnet, daß die Funktionen $h_k(t)$ die Funktionen $h_k(\tau + x) = C \cdot h_k(x)$ sind, worin x eine beliebige veränderliche Größe und C eine derartige Koeffizientenmatrix sind, daß die k Mittelwerte $\langle E(t) \cdot f_k(t)_N \rangle$ mit $\langle E(t) \cdot f_k(t) \rangle = X_{N+1} - C \cdot X_N$ erhalten werden, worin $X_N = {}_0\!\int^{N\tau} E(t) \cdot h_k(N\tau - t)$ und $S_{N+1} = {}_0\!\int^{(N+1)\tau} E(t) \cdot h_k((N+1)\tau - t)$ sind, wobei N eine Ganzzahl, $X_N$ und $X_{N+1}$ die nach der Filterung am Ende der jeweiligen Zeiten Nτ und (N+1)τ erhaltenen Ergebnisse sind.

4. Verfahren zur Wiedergewinnung eines Analogsignals E(t) nach Anspruch 1, dadurch gekennzeichnet, daß die Zeitfunktionen $f_k(t)$ vom Typ $f_n(t) = n \cdot (1-t)^{n-1}$ sind.

5. Verfahren zur Wiedergewinnung eines Analogsignals E(t) nach Anspruch 4, dadurch gekennzeichnet, daß die Funktionen $f_k(t)$ aus vier Funktionen bestehen:

$f_1(t) = 1$; $f_2(t) = 2(1-t)$; $f_3(t) = a(1-t)^2$; $f_4(t) = 4(1-t)^3$.

6. Verfahren zur Wiedergewinnung eines Analogsignals E(t) nach einem der Ansprüche 1 bis 5, dadurch gekennzeichnet, daß eine der Fehlerfunktionen durch den mittleren quadratischen Fehlerwert bestimmt wird: $\langle r^2 \rangle = \langle (E(t)-S(t))^2 \rangle$.

7. Verfahren zur Wiedergewinnung eines Analogsignals E(t) nach einem der Ansprüche 1 bis 6, dadurch kennzeichnet, daß eine der Fehlerfunktionen durch den Unterschied zwischen dem maximalen und dem minimalen Wert des wiedergewonnenen berechneten Signals S(t) bzw. durch die Werte einer der von den für jede Analysenperiode τ bestimmten maximalen (SUP) und minimalen (INF)-Werte des Analogsignals E(t) gebildeten "Schablonen" bestimmt wird.

8. Verfahren zur Wiedergewinnung eines Analogsignals E(t) nach Anspruch 6, dadurch gekennzeichnet, daß damit eine Bestimmung des quadratischen Mittelwerts des Analogsignals E(t) durchgeführt wird.

9. Verfahren zur Wiedergewinnung eines Analogsignals E(t) nach einem der vorangehenden Ansprüche, dadurch gekennzeichnet, daß die Wahl des Darstellungsbetriebs des wiedergewonnenen Nutzsignals X(t), d.h. zwischen dem Umhüllenden- und/oder dem Signalbetrieb je Analysenperiode τ entsprechend einer oder mehreren, für jede Fehlerfunktion bestimmten Klemmen in Abhängigkeit von der gesuchten Genauigkeit für das wiedergewonnene Nutzsignal X(t) automatisch erfolgt, wobei bei der Wahl davon ausgegangen wird, daß die Fehlerfunktionen entweder unabhängig oder gegenseitig verknüpft sind.

10. Verfahren zur Wiedergewinnung eines Analogsignals E(t) nach einem oder mehreren der vorangehenden Ansprüche, dadurch gekennzeichnet, daß damit außerdem wenigstens eine Fehlerfunktion sichtbar gemacht und/oder nachträglich bearbeitet wird.

11. Anordnung zum Erhalten eines aus einem Analogsignal E(t) wiedergewonnenen Nutzsignals X(t) zur Durchführung des Verfahrens nach einem der Ansprüche 1 bis 10, wobei das Signal X(t) zum sequentiellen Sichtbarmachen und/oder Bearbeiten bestimmt und dabei je Analysenzeit entweder aus im Signaldarstellungsbetrieb wiedergegebenen Signalproben eines wiedergewonnenen berechneten Signals S(t) oder aus im Umhüllenden Darstellungsbetrieb wiedergegebenen minimalen und maximalen Werten des Analogsignals E(t) aufgebaut ist, dadurch gekennzeichnet, daß das Analogsignal E(t) zu einem Analogprozessor (10) gelangt, der folgende Elemente enthält:
- eine Bearbeitungsschaltung (30) zur Bearbeitung des Analogsignals E(t) mit den an das Durchlaßband des Signals E(t) angepaßten Funktionen $f_k(t)$, wobei die Bearbeitungsschaltung aus k Vervielfachungsschaltungen (100$_1$ bis 100$_k$) zum Vervielfachen des Signals E(t) mit den k Funktionen $f_k(t)$ gefolgt von je einer Vervielfachungsschaltung zugeordneten k Integrationseinrichtungen (110$_1$ bis 110$_k$), gefolgt von je einer Integrationseinrichtung zugeordneten k Abtastern (120$_1$ bis 120$_k$), deren k Ausgänge (30$_1$ bis 30$_k$) mit den Eingängen des Abspeicherungs- und Digitalisierungselemente (17) versehen sind,
- und Mittel zum Wählen des Darstellungsbetriebs, die sich wenigstens auf einer Fehlerfunktion basieren, die die Abweichung zwischen dem wiedergewonnenen berechneten Signal S(t) und dem Analogsignal E(t) kennzeichnet, wobei die Ausgänge des Abspeicherungs- und Digitalisierungselements in eine Rechen- und Prüfeinrichtung (50) eintreten, die

a) ein Sichtbarmachungs- und/oder Bearbeitungselement (18) mit Synchronisationssignale und Taktsignale sowie mit dem wiedergewonnenen Nutzsignal X(t) und ggf. mit den Signalen der Fehlerfunktion(en) beliefert um für jede Analysenperiode $\tau$ die Wahl des Darstellungsbetriebs zu ermöglichen;

b) den Analogprozessor (10) mit Nullrückstellsignalen und einen Taktgeber (15) mit Synchronisationssignalen beliefert, der den Funktionstakt des Analogprozessors (10) auf das Abspeicherungs- und Digitalisierungselement (17) und auf die Rechen- und Prüfeinrichtung (50) überträgt.

12. Anordnung zum Erhalten eines wiedergewonnenen Nutzsignals X(t) aus einem Analogsignal E(t) zur Durchführung des Verfahrens nach einem der Ansprüche 1 bis 10, wobei das Signal X(t) zum sequentiellen Sichtbarmachen und/oder Bearbeiten bestimmt und dabei je Analysenzeit $\tau$ entweder aus im Signaldarstellungsbetrieb wiedergegebenen Signalproben eines wiedergewonnenen berechneten Signals S(t) oder aus im Umhüllenden-Darstellungsbetrieb wiedergegebenen minimalen und maximalen Werten des Analogsignals E(t) aufgebaut ist, <u>dadurch gekennzeichnet</u>, daß das Analogsignal E(t) an einen Analogprozessor (10) gelangt, der folgende Elemente enthält:

- eine Bearbeitungsschaltung (30) zum Bearbeiten des Analogsignals E(t) mit den an das Durchlaßband des Signals E(t) angepaßten Funktionen $f_k(t)$, wobei die Bearbeitungsschaltung durch die Reihenschaltung ($501_1$, $505_1$, $510_1$) bis ($501_k$, $505_k$, $510_k$) oder durch die Parallelschaltung ($600_1$ bis $600_k$) von k elementaren Filterstufen mit den jeweils zugeordneten Ausgängen $A_1 ... A_k$ und mit jeweils diesen Ausgängen zugeordneten Transmittanzen $h_1(t) ... h_k(t)$ gebildet ist, daß $h_k(t) = f_k(\tau-t)$ ist, wobei die Ausgänge $A_1 ... A_k$ mit k Abtastern ($520_1$ bis $520_k$) ($620_1$ bis $620_k$) verbunden sind, die in der Analysenperiode $\tau$ im Betrieb sind, und deren k Ausgänge mit den Eingängen des Abspeicherungs- und Digitalisierungselements (17) verbunden sind,

- und Mittel zum Wählen des Darstellungsbetriebs, die auf wenigstens einer Fehlerfunktion basieren, die die Abweichung zwischen dem wiedergewonnenen berechneten Signal S(t) und dem Analogsignal E(t) kennzeichnet, wobei die Ausgänge des Abspeicherungs- und Digitalisierungselements an eine Rechen- und Prüfeinrichtung (50) gelangen, die:

a) ein Sichtbarmachungs- und/oder Bearbeitungselement (18) mit Synchronisationssignalen und mit Taktsignalen sowie mit dem wiedergewonnen Nutzsignal X(t) und ggf. mit den Signalen der Fehlerfunktion(en) beliefert, um für jede Analysenperiode $\tau$ die Wahl des Darstellungsbetriebs zu ermöglichen,

b) den Analogprozessor (10) mit Nullrückstellsignalen und einen Taktgeber (15) mit Synchronisationssignalen beliefert, der den Funktionstakt des Analogprozessors (10) auf das Abspeicherungs- und Digitalisierungselement (17) und auf die Rechen- und Prüfeinrichtung (50) überträgt.

13. Anordnung zum Erhalten eines wiedergewonnenen Nutzsignals X(t) aus einem Analogsignal E(t) zur Durchführung des Verfahrens nach einem der Ansprüche 1 bis 10, wobei das Signal X(t) zum sequentiellen Sichtbarmachen und/oder Bearbeiten bestimmt und dabei je Analysenperiode $\tau$ entweder aus im Signaldarstellungsbetrieb wiedergegebenen Signalproben eines wiedergewonnenen berechneten Signals S(t) oder aus im Umhüllenden-Darstellungsbetrieb wiedergegebenen minimalen und maximalen Werten des Analogsignals E(t) aufgebaut ist, <u>dadurch gekennzeichnet</u>, daß das Analogsignal E(t) an einen Analogprozessor (10) gelangt, der folgende Elemente enthält:

- eine Bearbeitungsschaltung (30) zum Bearbeiten des Analogsignals E(t) mit den an das Durchlaßband des Signals E(t) angepaßten Funktionen $f_k(t)$ derart, daß $f_n(t) = n(1-t)^{n-1}$ ist, wobei die Produkte $<E(t) \cdot f_k(t)>$ geschrieben werden als $<E(t) \cdot f_n(t)> = P_n(t) = -n<P_{n-1}(t)>$, $n \, \varepsilon |1,k|$, wobei die Bearbeitungsschaltung aus k Integratoren ($140_1$, $140_k$) besteht, die für die Dauer einer Analysenperiode $\tau$ arbeiten, wobei der erste Integrator ($140_1$) einen Verstärkungsgrad -1 und der k. Integrator ($140_k$) einen Verstärkungsgrad -k besitzt, diese Integratoren in Reihe geschaltet sind, und ebenfalls mit den Ausgängen an je einem der k Abtaster ($120_1$ bis $120_k$) verbunden sind, deren k Ausgänge mit den Eingängen eines Abspeicherungs- und Digitalisierungselement (17) verbunden sind,

- und Mittel zum Wählen des Darstellungsbetriebs, der wenigstens auf einer Fehlerfunktion basiert, die die Abweichung zwischen dem wiedergewonnenen berechneten Signal S(t) und dem Analogsignal E(t) kennzeichnet, wobei die Ausgänge des Abspeicherungs- und Digitalisierungselements an eine Rechen- und Prüfeinrichtung (50) gelangen, die

a) ein Sichtbarmachungs- und/oder Bearbeitungselement (18) mit Synchronisationssignalen und mit Taktsignalen sowie mit dem wiedergewonnenen Nutzsignal X(t) und ggf. mit den Signalen der Fehlerfunktion(en) beliefert, um die Wahl des Darstellungsbetriebs für jede Analysenperiode $\tau$ zu ermöglichen,

b) den Analogprozessor (10) mit Nullrückstellsignalen und einen Taktgeber (15) mit Synchronisationssignalen beliefert, der den Funktionstakt des Analogprozessors (10) auf das Abspeicherungs- und Digitalisierungselement (17) und auf die Rechen- und Prüfeinrichtung (50) überträgt.

14. Anordnung zum Erhalten eines wiedergewonnenen Nutzsignals X(t) nach Anspruch 13, <u>dadurch gekennzeichnet</u>, daß die Variable k gleich 4 ist.

15. Anordnung zum Erhalten eines wiedergewonnenen Nutzsignals X(t) nach einem der Ansprüche 11 bis 14, <u>dadurch gekennzeichnet</u>, daß der Analogprozessor (10) einen Quadrierer (200) des Analogsignals E(t) enthält, dessen Ausgangssignal an einen Signalintegrator (205) gefolgt von einem ersten Abtasteinrichtung ($310_0$)

gelangt, deren Ausgang mit der Rechen- und Prüfeinrichtung (50) verbunden ist, die den mittleren quadratischen Fehler $<r^2>$ als Fehlerfunktion bestimmt, und ihn an einer Klemme Bo vergleicht, um die Wahl des Darstellungsbetriebs zu ermöglichen.

16. Anordnung zum Erhalten eines wiedergewonnenen Nutzsignals X(t) nach einem der Ansprüche 12 bis 15, dadurch gekennzeichnet, daß der Analogprozessor (10) zwei Spitzendetektoren (210) und (220) enthält, die den Maximalwert SUP und den Mindestwert MIN des Analogsignals E(t) in der Analysenperiode $\tau$ an den betreffenden Klemmen bestimmt, wobei diesen Detektoren eine zweite $(310_1)$ und eine dritte $(310_2)$ Abtasteinrichtung folgt, die die maximalen und minimalen Werten eines Musters liefern, in dessen Rahmen die maximalen Werte SUP (S(t)) und Mindestwerten INF (S(t)) des wiedergewonnenen berechneten Signals S(t) fallen müssen, um die Wahl des Darstellungsbetriebs zu ermöglichen.

17. Anordnung zum Erhalten eines wiedergewonnenen Nutzsignals X(t) nach Anspruch 15 und 16, dadurch gekennzeichnet, daß die Wahl des Darstellungsbetriebs nach folgender Tabelle erfolgt:

$$r^2 \geqslant B_0 \qquad X(t) = (SUP, INF)$$

$$r^2 < B_0 \quad \begin{array}{c} A < B_1 \\ \text{und} \\ B < B_2 \end{array} \qquad X(t) = S(t)$$

$$\begin{array}{c} A > B_1 \\ \text{oder} \\ B > B_2 \end{array} \qquad X(t) = (SUP, INF)$$

worin

$A = |SUP - SUP (S(t))|$

$B = |INF - INF (S(t))|$

und $B_1$ und $B_2$ die vorgegebenen Fehlerklemmen sind.

18. Anordnung zum Erhalten eines wiedergewonnenen Nutzsignals X(t) nach einem der Ansprüche 13 bis 17, dadurch gekennzeichnet, daß die Integrationseinrichtungen $(110_1$ bis $110_k)$ und/oder die Integratoren $(140_1$ bis $140_k)$ und/oder der Signalintegrator (205) und/oder die elementaren Filterstufen $((501_1, 505_1, 510_1)$ bis $(501_k, 505_k, 510_k)$ $(600_1$ bis $600_k))$ durch Widerstands/Kapazitätsstrukturen gebildet werden.

19. Anordnung zum Erhalten eines wiedergewonnenen Nutzsignals X(t) nach einem der Ansprüche 11 bis 18, dadurch gekennzeichnet, daß das Abspeicherungs- und Digitalisierungselement (17) aus einem Analogspeicher (20), einem Analog/Digitalwandler (32) und einem Digitalspeicher (22) besteht.

20. Anordnung zum Erhalten eines wiedergewonnenen Nutzsignals X(t) nach einem der Ansprüche 11 bis 18, dadurch gekennzeichnet, daß das Abspeicherungs- und Digitalisierungselement (17) aus einem Analog/Digital-Wandler (32) und einem Digitalspeicher (22) besteht.

21. Anordnung zum Erhalten eines wiedergewonnenen Nutzsignals X(t) nach Anspruch 19, dadurch gekennzeichnet, daß der Analogspeicher (20) eine Ladungsübertragungseinrichtung ist.

22. Anordnung zum Erhalten eines wiedergewonnenen Nutzsignals X(t) nach einem der Ansprüche 11 bis 21, dadurch gekennzeichnet, daß das erwähnte Verfahren und die erwähnte Einrichtung zum Sichtbarmachen und/oder Bearbeiten eines wiedergewonnenen Nutzsignals X(t) in einem Oszillografen verwendet werden.

23. Oszillograf, dadurch gekennzeichnet, daß er mit einer Anordnung zum Erhalten eines wiedergewonnenen Nutzsignals X(t) nach einem der Ansprüche 12 bis 22 verwendet wird.

**Claims**

1. A method of reconstituting an analog signal E(t) in the form of a useful reconstituted signal X(t) intended to be displayed and/or processed and formed per analysis period $\tau$, either from the samples of the calculated reconstituted signal S(t) represented in the signal display mode or from the minimum and maximum values or the analog signal E(t) represented in the envelope display mode, characterized in that it comprises the following steps:
- separate multiplication of the analog signal E(t) by k functions of the time $f_k(t)$ in order to obtain k products $E(t) \cdot f_k(t)$, and calculation of their respective mean values in order to obtain k mean values $<E(t) \cdot f_k(t)>$ at the end of each analysis period $\tau$, the functions $f_k(t)$ being chosen so that the pass band covered thereby is adapted to the pass band of the analog signal E(t);
- determination of the k coefficients $S_k$ by $S_k = M^{-1} \cdot <E(t) \cdot f_k(t)>$, where $M^{-1}$ is the inverse of the matrix M, so that

$$M = \begin{vmatrix} <f_1 \cdot f_1> & \cdots\cdots\cdots\cdots\cdots\cdots\cdots\cdots\cdots & <f_n \cdot f_1> \\ & \bullet & \bullet \\ & & \\ & \bullet & \bullet \\ <f_1 \cdot f_n> & \cdots\cdots\cdots\cdots\cdots\cdots\cdots\cdots\cdots & <f_n \cdot f_n> \end{vmatrix}$$

where $f_1$ and $f_n$ represent the first function $f_1(t)$ and the last function $f_n(t)$, respectively, of the k functions $f_k(t)$;

- determination of the calculated reconstituted signal S(t) by:

$$S(t) = S_k \cdot f_k(t);$$

- selection of the representation in the envelope mode or the signal mode in accordance with a representation selection criterion which is based on at least one error function determined between the calculated reconstituted signal S(t) and the analog signal E(t);
- display and/or processing of the reconstituted useful signal X(t).

2. A method of reconstituting an analog signal E(t) as claimed in Claim 1, characterized in that the k average values $<E(t) \cdot f_k(t)>$ are obtained over an analysis period $\tau$ by determining the k mean values $< E(t) \cdot h_k(\tau$ $-t)>$ by a pulse response filtering operation $h_k(t) = f_k(\tau\text{-}t)$.

3. A method of reconstituting an analog signal E(t) as claimed in Claim 2, characterized in that the functions $h_k(t)$ are the functions $h_k(\tau+x) = C \cdot h_k(x)$, x being an arbitrary variable and C being a matrix of coefficients, so that the k mean values $<E(t) \cdot f_k(t)>$ are obtained by:

$$<E(t) \cdot f_k(t) > = X_{N+1}\text{-}C \cdot X_N$$

with:

$$X_N = {}_0\!\int^{N\tau} E(t) \cdot h_k(N\tau\text{-}t)$$

and:

$$X_{N+1} = {}_0\!\int^{(N+1)\tau} E(t) \cdot h_k((N+1)\,\tau\text{-}t)$$

N being an integer and $X_N$ and $X_{N+1}$ being the results obtained after the filtering operation at the end of the respective periods $N\tau$ and $(N+1)\tau$.

4. A method of reconstituting an analog signal E(t) as claimed in Claim 1, characterized in that the time functions $f_k(t)$ are of the type $f_n(t) = n \cdot (1\text{-}t)^{n-1}$.

5. A method of reconstituting an analog signal E(t) as claimed in Claim 4, characterized in that the functions $f_k(t)$ amount to four in number:

$$f_1(t) = 1; \; f_2(t) = 2(1\text{-}t); \; f_3(t) = 3(1\text{-}t)^2; \; f_4(t) = 4(1\text{-}t)^3.$$

6. A method of reconstituting an analog signal E(t) as claimed in any one of the Claims 1 to 5, characterized in that one of the error functions is defined by the value of the mean quadratic error:

$$<r^2> = <(E(t)\text{-}S(t)^2)>$$

7. A method of reconstituting an analog signal E(t) as claimed in any one of the Claims 1 to 5, characterized in that one of the error functions is defined by the gap between the maximum and the minimum of the calculated reconstituted signal S(t) and the values of a series constituted by the maximum values (SUP) and minimum values (INF) of the analog signal E(t) determined for each analysis period $\tau$.

8. A method of reconstituting an analog signal E(t) as claimed in Claim 6, characterized in that it comprises determination of the mean quadratic value of the analog signal E(t).

9. A method of reconstituting an analog signal E(t) as claimed in any one of the preceding Claims, characterized in that the choice of the mode of representation of the reconstituted useful signal X(t), i.e. the envelope mode and/or the signal mode, is automatically made per analysis period $\tau$ in dependence of one or more respective limit values defined for each function error as a function of the precision required for the reconstituted useful signal X(t), which choice is made taking into account the error functions either independently or in combination with each other.

10. A method of reconstituting an analog signal E(t) as claimed in any one of the preceding Claims, characterized in that, moreover, at least one error function is displayed and/or subsequently processed.

11. A device for deriving a reconstituted useful signal X(t) from an analog signal E(t) in order to carry out the method claimed in any one of the Claims 1 to 10, which signal $X(t)$ is intended to be sequentially displayed and/or processed and is formed per analysis period $\tau$ either from the samples of a calculated reconstituted signal $S(t)$ represented in the signal mode or from the minimum and maximum values of the analog signal $E(t)$ represented in the envelope mode, characterized in that the analog signal $E(t)$ is applied to an analog processor (10) which comprises:

- a processing circuit (30) for processing the analog signal $E(t)$ by the functions $f_k(t)$ adapted to the pass band of the signal $E(t)$, the processing circuit being formed by k circuits ($100_1$ to $100_k$) for multiplying the signal $E(t)$ by the k functions $f_k(t)$, followed by k respective integration devices ($110_1$ to $110_k$), followed by k respective samplers ($120_1$ to $120_k$) whose k outputs ($30_1$ to $30_k$) are connected to the inputs of the storage and digitization member (17),

- and means for selecting the representation mode on the basis of at least one error function which characterizes the gap between the reconstituted calculated signal $S(t)$ and the analog signal $E(t)$, the outputs of the storage and digitization member being applied to a calculation and test device (50) which supplies:

a) a display and/or processing member (18) with synchronization signals and timing signals as well as with the reconstituted useful signal $X(t)$ and possibly with the signals of the error function or error functions in order to enable the selection of the representation mode per analysis period $\tau$.

b) the analog processor (10) with signals for resetting to zero and a timer (15) with synchronization signals, which timer impresses the operation timing on the analog processor (10), on the storage and digitization member (17), and on the calculation and test device (50).

12. A device for deriving a reconstituted useful signal $X(t)$ from an analog signal $E(t)$ in order to carry out the method claimed in any one of the Claims 1 to 10, which signal $X(t)$ is intended to be sequentially displayed and/or processed and is formed per analysis period $\tau$ either from the samples of a calculated reconstituted signal $S(t)$ represented in the signal mode or from the minimum and maximum values of the analog signal $E(t)$ represented in the envelope mode, characterized in that the analog signal $E(t)$ is applied to an analog processor (10) which comprises:

- a processing circuit (30) for processing the analog signal $E(t)$ by the functions $f_k(t)$ adapted to the pass band of the signal $E(t)$, the processing circuit being formed by the series connection ($501_1$, $505_1$, $510_1$) to ($501_k$, $505_k$, $510_k$) or the parallel connection ($600_1$ to $600_k$) of k elementary filtering stages having outputs $A_1 ... A_k$, respectively, and transmittances $h_1(t) ... h_k(t)$ at their outputs, so that $h_k(t) = f_k(\tau - t)$, the outputs $A_1 ... A_k$ being connected to k samplers ($520_1$ to $520_k$) ($620_1$ to $620_k$), operating for the analysis period $\tau$, whose k outputs are connected to the inputs of the storage and digitization member (17),

- and means for selecting the representation mode on the basis of at least one error function which characterizes the gap between the reconstituted calculated signal $S(t)$ and the analog signal $E(t)$, the outputs of the storage and digitization member being applied to a calculation and test device (50) which supplies:

a) a display and/or processing member (18) with synchronization signals and timing signals as well as with the reconstituted useful signal $X(t)$ and possibly with the signals of the error function or error functions in order to enable the selection of the representation mode per analysis period $\tau$,

b) the analog processor (10) with signals for resetting to zero and a timer (15) with synchronization signals, which timer impresses the operation timing on the analog processor (10), on the storage and digitization member (17), and on the calculation and test device (50).

13. A device for deriving a reconstituted useful signal $X(t)$ from an analog signal ($E(t)$ in order to carry out the method claimed in any one of the Claims 1 to 10, which signal $X(t)$ is intended to be sequentially displayed and/or processed and is formed per analysis period $\tau$ either from the samples of a calculated reconstituted signal $S(t)$ represented in the signal mode or from the minimum and maximum values of the analog signal $E(t)$ represented in the envelope mode, characterized in that the analog signal $E(t)$ is applied to an analog processor (10) which comprises:

- a processing circuit (30) for processing the analog signal $E(t)$ by the functions $f_k(t)$ adapted to the pass band of the signal $E(t)$, so that $f_n(t) = n(1-t)^{n-1}$, for which the products $<E(t) \cdot f_k(t)>$ are written as $<E(t) \cdot f_n(t) = P_n(t) = -n <P_{n-1}(t)>$, $n\ \varepsilon|1,k|$, the processing circuit being formed by k series-connected integrators ($140_1$, $140_k$) which operate during an analysis period $\tau$ the first integrator ($140_1$) having a gain -1 and the $k^{th}$ integrator ($140_k$) having a gain -k, and being connected at their outputs to k samplers ($120_1$ to $120_k$) whose k outputs are connected to the inputs of a storage and digitization member (17),

- and means selecting the representation mode on the basis of at least one error function which characterizes the gap between the reconstituted calculated signal $S(t)$ and the analog signal $E(t)$, the outputs of the storage and digitization member being applied to a calculation and test device (50) which supplies:

a) a display and/or processing member (18) with synchronization signals and timing signals as well as with the reconstituted useful signal $X(t)$ and possibly with the signals of the error function or error functions in order to enable the selection of the representation mode per analysis period $\tau$,

b) the analog processor (10) with signals for resetting to zero and a timer (15) with synchronization signals, which timer impresses the operation timing on the analog processor (10), on the storage and digitization member (17), and on the calculation and test device (50).

14. A device for deriving a reconstituted useful signal $X(t)$ as claimed in Claim 13, characterized in that the variable k is equal to 4.

15. A device for deriving a reconstituted useful signal $X(t)$ as claimed in any one of the Claims 11 to 14, characterized in that the analog processor (10) comprises a squaring device (200) for the analog signal $E(t)$, the output of which is applied to a signal integrator (205) which is followed by a first sampling device ($310_0$) whose output is connected to the calculation and test device (50) which determines the mean quadratic error $<r^2>$ used as the error function and compares it with a limit value Bo in order to enable the mode of representation to be chosen.

16. A device for deriving a reconstituted useful signal X(t) as claimed in any one of the Claims 12 to 15, characterized in that the analog processor (10) comprises two peak detectors (210) (220) which determine the maximum SUP and the minimum INF, respectively, of the analog signal E(t) during the analysis period $\tau$, inclusive of the limit values, which detectors are followed by a second ($310_1$) and a third ($310_2$) sampling device, respectively, which supply the maximum and minimum values of a set which serves to define the maximum value SUP (S(t)) and the minimum value INF (S(t)) of the calculated reconstituted signal S(t) in order to enable the mode of representation to be chosen.

17. A device for deriving a reconstituted useful signal X(t) as claimed in the Claims 15 and 16, characterized in that the choice of the mode of representation is made in accordance with the table:

$$r^2 \geqslant B_0 \qquad X(t) = (SUP, INF)$$

$$r^2 < B_0 \qquad \begin{array}{c} A < B_1 \\ \text{and} \\ B < B_2 \end{array} \qquad X(t) = S(t)$$

$$\begin{array}{c} A > B_1 \\ \text{or} \\ B > B_2 \end{array} \qquad X(t) = (SUP, INF)$$

where
$A = |SUP - SUP\,(S(t))|$
$B = |INF - INF\,(S(t))|$

$B_1$ and $B_2$ being given error limit values.

18. A device for deriving a reconstituted useful signal X(t) as claimed in any one of the Claims 13 to 17, characterized in that the integrations devices ($110_1$ to $110_k$) and/or the integrators ($140_1$ to $140_k$) and/or the signal integrator (205) and/or the elementary filtering stages ($510_1$, $505_1$, $510_1$) to ($501_k$, $505_k$, $510_k$) ($600_1$ to $600_k$) are formed by RC structures.

19. A device for deriving a reconstituted useful signal X(t) as claimed in any of Claims 11 to 18, characterized in that the storage and digitization member (17) is constituted by an analog memory (20), by an analog-to-digital converter (32), and by a digital memory (22).

20. A device for deriving a reconstituted useful signal X(t) as claimed in any one of Claims 11 to 18, characterized in that the storage and digitization member (17) is constituted by an analog-to-digital converter (32) and by a digital memory (22).

21. A device for deriving a reconstituted useful signal X(t) as claimed in Claim 19, characterized in that the analog memory (20) is a charge transfer device.

22. A device for deriving a reconstituted useful signal X(t) as claimed in any one of Claims 11 to 21, characterized in that the said method and device are utilized to display and/or process in an oscilloscope a useful reconstituted signal X(t).

23. An oscilloscope, characterized in that it utilizes a device for deriving a reconstituted useful signal X(t) as claimed in any one of Claims 12 to 22.

18

FIG.1

FIG.2

FIG.3

FIG.4

FIG.5

FIG.6